(19) Europäisches Patentamt
European Patent Office
Office européen des brevets

(11) **EP 1 306 941 A1**

(12) **DEMANDE DE BREVET EUROPEEN**

(43) Date de publication:
**02.05.2003 Bulletin 2003/18**

(51) Int Cl.7: **H01S 5/14**, H01S 5/125, G02B 6/12

(21) Numéro de dépôt: **02292438.5**

(22) Date de dépôt: **03.10.2002**

(84) Etats contractants désignés:
**AT BE BG CH CY CZ DE DK EE ES FI FR GB GR IE IT LI LU MC NL PT SE SK TR**
Etats d'extension désignés:
**AL LT LV MK RO SI**

(30) Priorité: **15.10.2001 FR 0113261**

(71) Demandeur: **ALCATEL**
**75008 Paris (FR)**

(72) Inventeurs:
• **Duang, Guang Hua**
**92290 Chatenay Malabry (FR)**

• **Helmers, Hakon**
**92330 Sceaux (FR)**
• **Leroy, Arnaud**
**75014 Paris (FR)**
• **Jacquet, Jöel**
**91470 Limours (FR)**

(74) Mandataire: **Fournier, Michel et al**
**Compagnie Financière Alcatel,**
**Intellectual Property Department,**
**5, rue Noel Pons**
**92734 Nanterre Cedex (FR)**

(54) **Cavité optique résonante sur une plage continue de fréquence**

(57) Une cavité résonante (50) optique délimitée entre deux miroirs (13', 40) dont l'un (40) est un réseau réflecteur de Bragg à pas variable, est caractérisée en ce qu'un paramètre $C_s$ de variation de la longueur d'onde de Bragg du réseau est tel que la cavité est résonante de façon continue entre une première et une seconde fréquence optique supérieure à la première.

L'invention est utilisable notamment pour la réalisation de filtres passe bande large bande à flancs abrupts, d'amplificateurs large bande exempt d'ondulation de gain, ou encore de diodes électroluminescentes ou de lasers à spectre d'émission continu.

FIG. 1

EP 1 306 941 A1

## Description

### Domaine technique

L'invention se situe dans le domaine des cavités optiques, en particulier les cavités optiques laser.

### Art antérieur

Les cavités résonantes optiques de type Fabry-Pérot sont des cavités délimitées de façon longitudinale par deux réflecteurs un premier et un second. Toutes les longueurs d'ondes optiques pour lesquelles la dimension de la cavité est égale à un nombre entier de demi-longueurs d'onde correspondent à des modes résonants de la cavité. Ainsi pour une dimension donnée de cavité, il y a une infinité de longueurs d'onde conduisant à des modes résonants. Une cavité classique de Fabry-Pérot est ainsi constituée de deux miroirs. Dans une autre cavité connue l'un des réflecteurs est constitué par un réseau réflecteur de Bragg gravé sur un guide d'onde, par exemple une fibre. Une cavité ainsi constituée a plusieurs modes résonants qui correspondent à des valeurs de longueur d'onde proches des valeurs de Bragg, pour lesquelles existe un pic de réflexion du réflecteur.

Un point commun à ces deux cavités est que les valeurs de longueurs d'onde pour lesquelles la cavité est résonante sont des valeurs discrètes.

Il existe aussi quelques structures non résonantes telles que les diodes électroluminescentes et les amplificateurs à ondes progressives, permettant de générer des spectres continus. Dans de telles structures le gain de l'amplificateur présente des ondulations indésirables ou si l'on supprime les ondulations indésirables, le gain devient celui d'un amplificateur à onde progressive à un seul passage.

### Brève description de l'invention

Les structures résonantes permettent d'obtenir des coefficients de transmission plus élevés que ceux que l'on peut obtenir avec des structures non résonantes, mais par leur nature même, elles sont très sensibles à de petites variations de longueur d'onde (ou de fréquence optique) de la lumière transmise.

Ainsi l'invention propose une cavité résonante ayant un fort coefficient de transmission et une réponse spectrale constante sur une plage continue comprise entre une valeur minimum et une valeur maximum de fréquence. Cette plage continue de fréquences correspond de façon connue à une plage continue de longueurs d'ondes comprises entre une première valeur maximum correspondant à la valeur minimum de fréquence de la plage continue de fréquences et une seconde valeur minimum correspondant à la valeur maximum de fréquence de la plage continue de fréquences.

A ces fins l'invention est relative à une cavité optique résonante ayant au moins une partie munie d'un premier guide d'onde orienté selon un axe longitudinal sur laquelle est définie une origine des distances, la cavité étant délimitée entre un premier et un second réflecteur, le second des réflecteurs étant un réseau réflecteur de Bragg à pas variable présent sur ledit premier guide d'onde, ledit réseau du second réflecteur ayant une extrémité proche du premier réflecteur et une extrémité plus éloignée dudit premier réflecteur, un paramètre $C_s$ de variation de longueur d'onde de Bragg défini comme la dérivée en un point du réseau réflecteur de la longueur d'onde de Bragg $\lambda_B$ en ce point par rapport à la distance séparant ce point à l'origine, ayant une valeur donnée, caractérisée en ce que ladite valeur du paramètre $C_s$ et la position dudit réseau par rapport à l'origine sont telles que la cavité formée entre ledit premier réflecteur et ledit second réflecteur est résonante de façon continue entre une première fréquence optique et une seconde fréquence optique supérieure à la première.

### Brève description des dessins

Des modes de réalisation de l'invention seront maintenant décrits en regard des dessins annexés dans lesquels :

- la figure 1 est un schéma représentant un premier mode de réalisation de l'invention;
- la figure 2 est une courbe qui représente la valeur que doit avoir le paramètre $C_s$ en fonction de la distance entre la face arrière d'un guide actif et l'extrémité du réseau de Bragg la plus proche de cette face;
- la figure 3 est un schéma représentant un second mode de réalisation de l'invention selon lequel le réseau de Bragg est inscrit dans une fibre optique;
- la figure 4 est une courbe qui représente dans le cas de la réalisation de la figure 3 la valeur que doit avoir le paramètre $C_s$ en fonction de la longueur de fibre sans réseau se trouvant entre la face avant d'un guide actif et le début du réseau de Bragg;
- la figure 5 représente un troisième mode de réalisation de l'invention;

La figure 6 représente un quatrième mode de réalisation dans lequel le premier et le second réflecteur de la cavité sont des réflecteurs de Bragg à pas variable.

Les éléments ayant même fonction que des éléments déjà commentés pour une figure et portant le même numéro de référence ne seront pas nécessairement commentés à nouveau pour une autre figure.

### Description de modes de réalisation

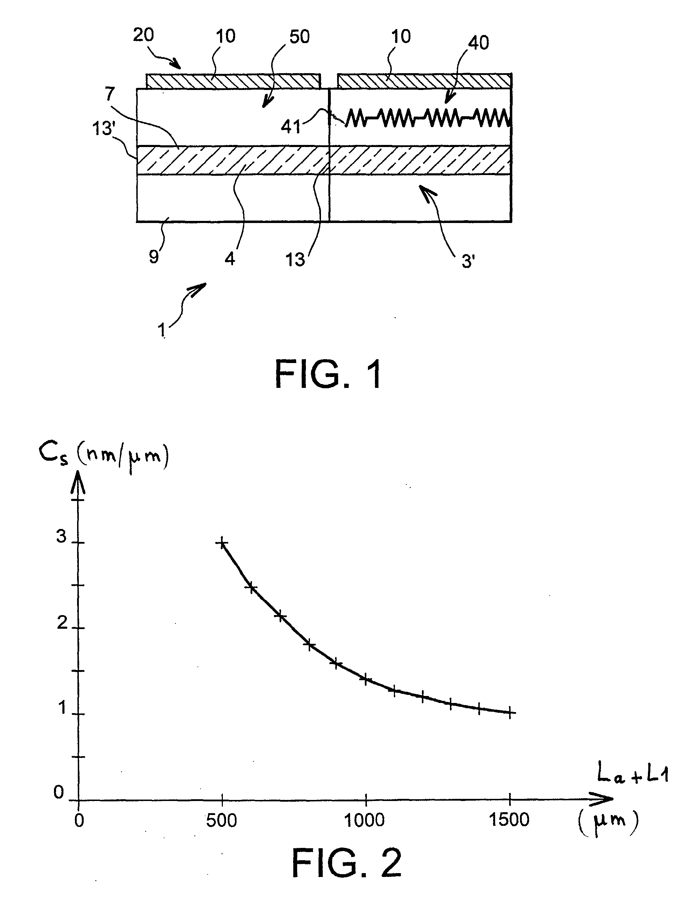

La figure 1 est un schéma représentant un premier mode de réalisation de l'invention.

Elle représente une partie active 20 ayant la structure d'un laser en semi-conducteur, par exemple à ruban superficiel ou enterré. De façon en elle-même connue la partie active 20 est réalisée sur un substrat semi-conducteur 9 et comporte un guide d'onde muni d'une couche semi-conductrice 4 permettant de rendre ce guide d'onde amplificateur ou non. La couche semi-conductrice 4 est disposée de façon en elle-même connue entre des couches de confinement électrique et optique non référencées sur les figures. Une couche métallique de contact 10, par exemple en AuPt, située au dessus des couches de confinement constitue une électrode supérieure qui coopère avec une électrode inférieure non représentée. Une face arrière 13' de cette partie active 20 est clivée ou traitée pour présenter un fort coefficient de réflexion.

Un guide d'onde intégré passif 3', comme représenté à la figure 1, est disposé dans le prolongement longitudinal de la couche semi-conductrice 4. Le guide d'onde 3' est optiquement couplé au guide d'onde la partie active 20. Un réflecteur de Bragg 40 est gravé sur le guide d'onde 3'.

Une cavité 50 de Fabry-Pérot est ainsi formée en deux parties couplées l'une à l'autre. Une première partie de la cavité est celle qui comporte le guide d'onde 3'. Une seconde partie 7 est celle de la partie active 20.

La face réfléchissante arrière 13' et le réflecteur de Bragg 40 constituent des premier et second réflecteurs opposés délimitant la cavité résonante 50.

Ainsi, dans le mode de réalisation décrit ci-dessus la cavité 50 comporte outre la première partie munie du premier guide d'onde 3' une autre partie 7 constituée par un guide en semi-conducteur situé dans le prolongement optique de ladite première partie et couplé optiquement au premier guide.

Des explications seront maintenant données sur le mode de réalisation du réseau réflecteur 40 de Bragg.

La longueur d'onde de Bragg centrale $\lambda_B$ en un point du réseau périodique de Bragg à inscrire sur le guide 3' est une fonction du pas du réseau $\Lambda$ et de l'indice n du guide selon la formule :

$$\lambda_B(L_B) = 2n\Lambda(L_B) \qquad (1)$$

Dans cette formule $L_B$ est la distance entre le début du réseau, c'est à dire l'extrémité 41 du réseau la plus proche de la partie active 20 et le point où la longueur d'onde centrale $\lambda_B$ du réseau est appréciée, c'est-à-dire où une onde ayant cette longueur d'onde (dans le vide) subit une réflexion. La formule (1) ci-dessus exprime que la longueur d'onde centrale $\lambda_B$ n'est pas constante, mais est une fonction de la distance $L_B$. On parle alors de réflecteur de Bragg "chirpé" (de l'anglais "chirped Bragg reflector").

Si cette fonction est choisie linéaire, le réflecteur est dit linéairement "chirpé" (en anglais : "linearly chirped reflector"). Un accroissement $\Delta L_B$ de la distance $L_B$ est alors proportionnel à un accroissement correspondant $\Delta \lambda_B$ de la longueur d'onde de Bragg centrale $\lambda_B$ du réseau au point considéré. On a donc $\Delta \lambda_B / \Delta L_B = C_s$, où $C_s$ est un constante appelée le paramètre de variation de la longueur d'onde de Bragg du réseau de Bragg (ou "paramètre de chirp du réseau").

La valeur de $C_s$ peut être comprise par exemple entre 0,1 nanomètre par centimètre pour un réseau gravé sur une fibre optique, et une valeur de 100 nanomètres par centimètre pour un guide d'onde intégré en InP lithographié par faisceau électronique comme expliqué dans l'article [1] dont la référence figure en annexe à la présente description.

Pour une lumière à la longueur d'onde $\lambda$ dans le vide, la condition de résonance de la cavité 50 formée en deux parties est donnée par la relation

$$n_a L_a + n_B L_B(\lambda) = m\lambda/2 \qquad (2)$$

Dans cette relation :

$n_a$ est l'indice optique de la partie 7 de la cavité.

$L_a$ est la longueur de ladite partie 7 de la cavité.

$n_a L_a$ est donc la longueur optique de ladite seconde partie de la cavité.

$n_B$ est l'indice optique de la partie 3' de la cavité, c'est à dire celui du guide d'onde supportant le réseau de Bragg.

$L_B$ est comme déjà expliqué la distance séparant le point du réseau de Bragg où $\lambda_B$ est appréciée et le début du guide.

$n_B L_B$ est donc la longueur optique de ladite première partie de la cavité.

La relation (2) exprime que la longueur optique de la cavité 50 en deux parties est égale à un nombre entier m de demi-longueurs d'onde de valeur $\lambda$.

Si l'on suppose que la relation (2) est vérifiée pour une longueur d'onde de Bragg minimum $\lambda_a$ correspondant par exemple à la seconde fréquence qui est la fréquence la plus élevée de la plage continue, et si l'on veut qu'elle soit aussi vérifiée pour tous les accroissements de valeurs $\Delta\lambda$ de longueur d'onde à partir de la longueur d'onde minimum $\lambda_a$ et ce jusqu'à une longueur d'onde maximum $\lambda_b$ correspondant par exemple à la première fréquence minimum, on doit avoir simultanément :

$$n_a L_a + n_B L_B(\lambda_a) = m\lambda_a/2 \qquad (2)$$

et

$$n_a L_a + n_B L_B(\lambda_a + \Delta\lambda) = m(\lambda_a + \Delta\lambda)/2 \qquad (3)$$

Il est connu que pour les fibres à réflecteur de Bragg à variation linéaire utilisées pour la compensation de la dispersion de phase, une onde ayant une longueur d'onde donnée (dans le vide) est réfléchie à l'endroit du réseau réflecteur où ladite longueur d'onde est égale à la longueur d'onde de Bragg. Si l'on admet ceci de façon générale, la longueur optique de la cavité est une fonction linéaire de la longueur d'onde de l'onde. Ceci se traduit par la relation

$$L_B(\lambda_a + \Delta\lambda) = L_B(\lambda_a) + \Delta\lambda dL_B/d\lambda \qquad (4)$$

Compte tenu des équations 2, 3 et 4, on obtient :

$$C_s = d\lambda_B/dL_B = n_B\lambda_a/[n_aL_a + n_BL_1] \qquad (5)$$

Dans cette relation, $L_1$ est la distance entre l'extrémité 41 du réseau de Bragg 40 et la face avant 13 de la seconde partie 7.

Cette relation exprime que dans le cas d'une relation linéaire entre $\lambda_B$ et $L_B$, la dérivée de $\lambda_B$ par rapport à $L_B$ en un point du guide comportant le réseau, c'est-à-dire la valeur du paramètre $C_s$, est égale au quotient de la longueur d'onde optique $n_B\lambda_a$ dans le premier guide d'onde 3' qui correspond à la longueur d'onde minimum de la plage (ou deuxième valeur de fréquence de la plage), par la distance optique séparant le premier réflecteur 13' et l'extrémité 41 du réseau 40 la plus proche du premier réflecteur 13'.

Ainsi, la valeur que doit avoir le paramètre $C_s$ est fonction de la position du réseau sur un axe longitudinal du guide 3'.

La figure 2 est une courbe qui représente la valeur que doit avoir le paramètre $C_s$ en fonction de la distance entre la face arrière 13' de la seconde partie 7 (partie active) et l'extrémité 41 du réseau 40, pour obtenir une variation continue de la longueur d'onde entre une valeur minimum et une valeur maximum ou ce qui revient au même entre une fréquence optique maximum et une fréquence optique minimum. La valeur du paramètre $C_s$ est en ordonnée. Elle est exprimée en nanomètres par micromètre. $C_s$ est exprimé en fonction de la somme de la longueur $L_a$ de la partie active et de la distance $L_1$ entre la face avant 13 de la couche active 4 et l'extrémité 41 du réseau 40 la plus proche de cette face avant 13. Cette somme de distances $L_a+L_1$ qui figure en abscisse est exprimée en micromètres. Pour le tracé de cette courbe les valeurs d'indice optique des deux parties ont été admises comme égales entre elles et voisines de 3,45. La longueur $L_a$ est de 500 μm. On constate que la valeur de $C_s$ est comprise entre 3 nm/μm et 1 nm/μm alors que la somme des distances est comprise entre 500 et 1500 μm.

Le document [1] déjà cité indique qu'un tel réseau à pas variable peut parfaitement être réalisé par lithographie par faisceau électronique. On constate aussi que la variation de $C_s$ en fonction de la distance n'est pas linéaire. Une réalisation remplissant les conditions de valeurs de $C_s$ montrées sur la figure 2 permet une variation continue de la longueur d'onde entre une première valeur minimum et une seconde valeur maximum ayant entre elles une différence par exemple de 20 à 30 nanomètres.

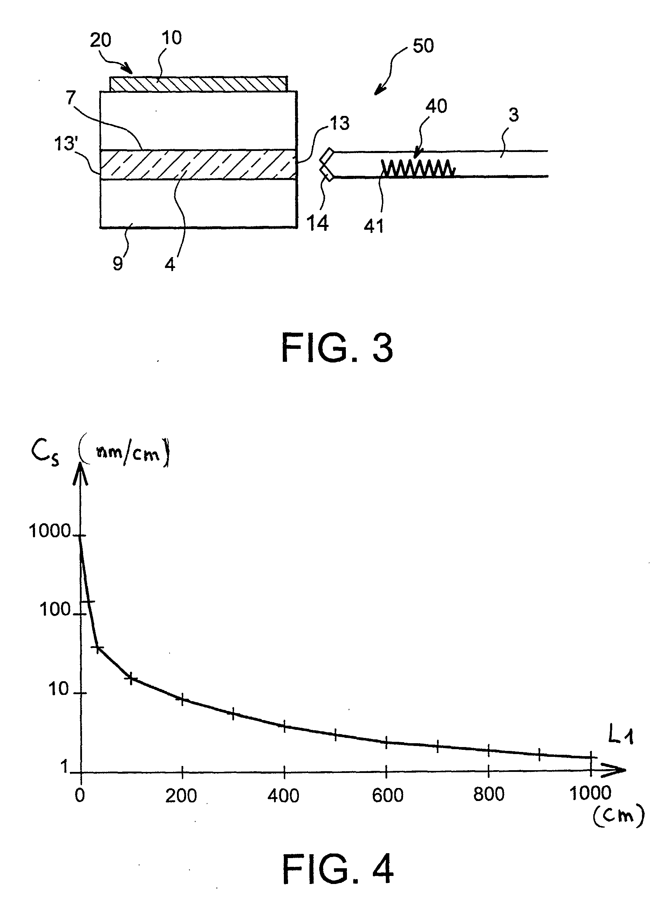

Une seconde configuration de l'invention sera maintenant décrite en liaison avec la figure 3.

Cette seconde configuration diffère de celle décrite en relation avec la figure 1 essentiellement par le fait que le guide d'onde 3' est formé par une fibre optique 3 couplée optiquement, par exemple par une lentille 14, à la seconde partie 7 (partie active 20). Une face avant 13 de cette partie 7 est traitée pour présenter un coefficient de réflexion aussi faible que possible et si possible nul. De la sorte la partie 7 forme avec la fibre 3 une seule cavité optique 50 de Fabry-Pérot allant d'un premier réflecteur formé par la face arrière 13' fortement réfléchissante de la seconde partie 7 au point de réflexion du second réflecteur formé par le réseau réflecteur de Bragg 40. Le principe de fonctionnement de la cavité est le même que celui décrit ci-dessus.

La figure 4 représente une courbe de la valeur que doit avoir le paramètre $C_s$ en fonction de la distance entre la face avant 13 et l'extrémité 41 du réseau 40 la plus proche de cette face avant 13. La valeur du paramètre $C_s$ portée en ordonnée est exprimée en nanomètres par centimètre. La distance entre la face avant 13 et l'extrémité 41 du réseau 40 portée en abscisse est exprimée en centimètres. Cette courbe a été tracée pour des valeurs d'indice optiques $n_a$ dans la couche 4 et $n_B$ dans la fibre respectivement de 1,45 et 3,45. La distance $L_a$ est comme dans le cas précédent de 500 μm.

La courbe montre que $C_s$ prend des valeurs comprises entre 1000 et environ 1,5 nm/cm lorsque la distance entre la face avant 13 et l'extrémité 41 du réseau 40 varie entre 0 et 10 mètres. On reste dans la gamme des valeurs qui peuvent être obtenues sur une fibre.

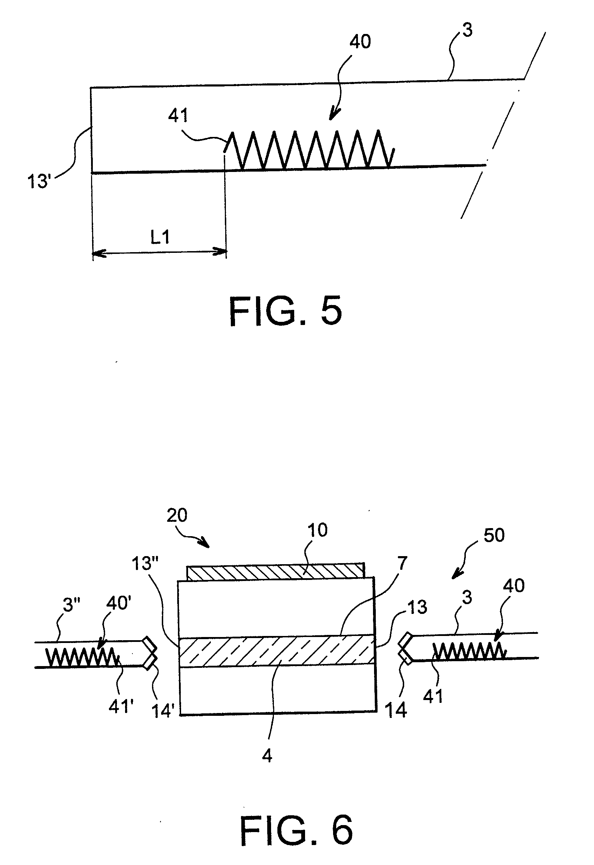

Une troisième configuration de l'invention sera maintenant commentée en liaison avec la figure 5. Dans ce mode de réalisation la cavité de Fabry-Pérot résonante de façon continue est réalisée entièrement à l'intérieur d'un guide d'onde par exemple en InP ou, comme représenté figure 5, d'une fibre 3. L'une des extrémités 13' de la fibre comporte un revêtement fortement réflecteur et la fibre comporte un réseau réflecteur 40 de Bragg ayant un paramètre de variation de la longueur d'onde de Bragg $C_s$. Le réseau 40 a une extrémité 41 à une distance $L_1$ du revêtement réflecteur 13'. L'extrémité 41 est la plus proche du réflecteur 13'. Le réseau 40 se prolonge au delà de la distance $L_1$. La valeur que doit prendre le paramètre $C_s$ est une fonction continue de la distance entre cette face arrière 13' et l'extrémité 41 dudit réseau de Bragg la plus proche de cette face. Dans ce mode de réalisation le premier réflecteur 13' est situé sur le même premier guide 3 que celui portant le réseau 40 réflecteur de Bragg formant le second réflecteur. Naturellement le revêtement réflecteur 13' peut être remplacé par un second réseau réflecteur de Bragg 40', non représenté sur la figure 5, présent sur le même guide d'onde 3 que celui formant le second réflecteur 40.

Le fonctionnement de ce mode de réalisation est analogue à celui décrit précédemment.

Un quatrième exemple de réalisation sera maintenant commenté en liaison avec la figure 6. La figure 6 est un exemple de réalisation dans lequel le premier et le second réflecteurs de la cavité 50 sont des réflecteurs de Bragg à pas variable. Cet exemple est semblable à celui de la figure 3, dans lequel la face arrière fortement réfléchissante 13' est remplacée par un second réflecteur de Bragg 40', présent sur un guide d'onde 3" qui est une fibre optique. Une partie active 20 est présente entre les deux réflecteurs 40, 40'. Cette partie active a deux faces : une face que l'on continuera à qualifier arrière 13" et une face avant 13, toutes deux aussi peu réfléchissantes que possible. La cavité 50 est ainsi formée entre les deux réflecteurs de Bragg 40, 40'.

Dans ce mode de réalisation le premier réflecteur est un second réseau 40' réflecteur de Bragg porté par un second guide d'onde 3', le premier et le second réflecteurs étant situé de part et d'autre de la partie active 20 en semi-conducteur.

Naturellement l'une ou les deux fibres 3, 3" portant les réseaux réflecteurs 40, 40' à pas variable respectivement pourraient être remplacés par un guide intégré dans une couche en semi-conducteur.

Le fonctionnement de ce mode de réalisation sera commenté ci-après.

Dans le cas où les deux réflecteurs sont constitués par des réseaux de Bragg 40, 40' présentant une variation continue de la longueur d'onde de Bragg du réseau de Bragg, et si les deux réseaux 40, 40' sont symétriques l'un de l'autre par rapport à un plan perpendiculaire à un axe longitudinal de la cavité alors la relation (5) donnant la valeur de $C_s$ rappelée ci-dessous :

$$C_s = d\lambda_B/dL_B = n_B\lambda_a/[\,n_aL_a + n_BL_1)] \qquad (5)$$

doit être remplacée par la relation :

$$C_s = d\lambda_B/dL_B = 2n_B\lambda_a/[n_aL_a + 2n_BL_1)] \qquad (6)$$

La condition de symétrie des réseaux n'est pas obligatoire. Si les réseaux de Bragg constituant le premier et le second réflecteur ne sont pas symétriques, la somme de l'inverse du premier paramètre $C_{s1}$ du premier réflecteur et de l'inverse du second paramètre $C_{s2}$ du second réflecteur est égale au quotient de la distance optique entre les extrémités 41 et 41' les plus proches l'une de l'autre des deux réseaux 40, 40' de Bragg à pas variable, par la longueur d'onde optique $n_B\lambda_a$ de la limite minimum de la plage de longueur d'onde dans les guides d'onde 3 et 3". Cela est reflété par la formule (7) ci-dessous :

$$1/C_{s1} + 1/C_{s2} = [n_aL_a + n_B(L1+ L2)]/ n_B\lambda_a \qquad (7)$$

Dans cette formule L1 est la distance entre la face avant 13 et le début 41 du réseau 40, L2 est la distance entre la face arrière 13" et le début 41' du réseau 40'.

Dans la formule (7), on a admis que les indices optiques $n_B$ des guides portant chacun des réseaux 40, 40' sont égaux entre eux. Si ces deux indices ne sont pas égaux entre eux mais égaux à $n_{B1}$ et $n_{B2}$ respectivement, la distance optique entre les extrémités 41, 41' les plus proches l'une de l'autre des deux réseaux 40, 40' devient $n_{B1}L_1 + n_{B2}L_2$.

Compte tenu des exemples qui viennent d'être donnés, on voit qu'il existe de nombreuse possibilités de réaliser une cavité de Fabry-Pérot selon l'invention, résonante de façon continue entre deux valeurs de longueur d'onde ou de fréquence optique. Cette cavité peut être réalisée dans un seul milieu optique, c'est à dire un milieu ayant une seule valeur d'indice optique. Elle peut aussi être réalisée par une mise en série de plusieurs milieux ayant chacun un indice optique propre. Les faces de jonction entre milieux formant ensemble la cavité résonante sur une plage continue seront de préférence traitées pour ne pas réfléchir la lumière. Les cavités conformes à l'invention se caractérisent par le fait qu'elles comportent toutes au moins un réseau réflecteur de Bragg présentant une variation continue de la longueur d'onde de Bragg du réseau de Bragg pour permettre une résonance de façon continue entre une première valeur et une seconde valeur de longueur d'onde. Ce réseau réflecteur de Bragg à pas variable constitue au moins l'un des réflecteurs de la cavité. Le second réflecteur de la cavité peut comme représenté sur les quatre exemples commentés, être constitué par une face fortement réfléchissante. Il peut aussi être réalisé par un second réseau réflecteur de Bragg, et en particulier par un second réseau réflecteur de Bragg présentant une variation continue de la longueur d'onde de Bragg.

Des utilisations avantageuses de cavités de Fabry-Pérot selon l'invention, résonantes de façon continue seront maintenant commentées à titre d'illustration de l'intérêt de telles cavités.

Une première utilisation avantageuse est relative à un amplificateur optique en semi-conducteur (SOA) large bande à résonance.

Dans un tel amplificateur, si le coefficient de réflectivité de l'une des faces délimitant la cavité optique a une valeur non négligeable mais inférieur à $10^{-3}$, le gain (rapport entre la puissance de sortie et la puissance d'entrée) de l'amplificateur présente en fonction de la longueur d'onde des ondulations indésirables. En général pour ne pas avoir ces ondulations indésirables les deux faces délimitant le milieu d'amplification sont traitées pour être non réfléchissantes. Cela supprime les ondulations indésirables, mais le gain devient celui d'un amplificateur à onde progressive à un seul passage.

L'utilisation d'un amplificateur ayant une structure telle que celle commentée en liaison avec la figure 1 des dessins annexés, permet d'obtenir une amplification optique sur une large bande, sans ondulations indésirables et avec un gain relativement important par rapport aux amplificateurs large bande connus n'ayant pas d'ondulations indésirables.

Ce gain plus important peut être obtenu sur une large bande avec un courant injecté qui reste inférieur au seuil acceptable par la structure amplificatrice.

Une seconde utilisation avantageuse est relative à un laser ou une diode électroluminescente à spectre d'émission continu.

Si le gain optique fourni par un courant injecté dans une structure telle que celle commentée avec la figure 1 est suffisant, la structure émet de la lumière ou commence à laser si les conditions de seuil sont réunies. Comme, avec une cavité selon l'invention la condition de résonance est satisfaite sur une large bande, la structure est apte à émettre un spectre continu pour autant que le spectre de gain du matériau actif est uniforme à l'intérieur de la bande de fréquences de résonance déterminée par le réseau réflecteur de Bragg. L'instabilité provenant de la forte interaction présente de façon connue entre les différentes composantes de fréquence peut être réduite voir rendue négligeable par une injection externe de lumière. Cette injection produit un verrouillage de mode sur la large bande de fréquence déterminée par le réseau réflecteur de Bragg. Il convient de noter que le verrouillage de mode se produit aussi de façon continue, lorsque la fréquence d'entrée de la lumière varie.

Une troisième utilisation d'une cavité selon l'invention est relative à la réalisation d'un filtre passe bande ayant des flancs abrupts.

Pour cette réalisation une cavité passive telle que celle commentée par exemple en relation avec la figure 5 peut être utilisée. Une onde incidente étant injectée par la face arrière 13', on obtient une onde filtrée en sortie réseau de Bragg 40. La courbe de transmission en fonction de la longueur d'onde d'une telle cavité est de type passe bande et présente des flancs plus abrupts que ceux qu'on peut obtenir avec un simple filtre à réseau de Bragg, ceci en raison de l'effet de résonance de la cavité. Pour obtenir une bonne réjection des composantes spectrales en dehors de la bande passante, la face arrière 13' et le réseau seront avantageusement conçus pour présenter un coefficient de réflexion proche de 1 pour les composantes spectrales de cette bande.

Une quatrième utilisation d'une cavité selon l'invention est relative à la réalisation d'une source laser accordable continuellement. Pour cette réalisation, une cavité active telle que l'une de celles commentées par exemple en relation avec la figure 1 ou la figure 3 peut être utilisée. Pour permettre une sélection de la longueur d'onde de fonctionnement de ladite source laser, la partie active du laser est modulée électriquement, à une fréquence de modulation dont la période est égale au temps d'aller et retour de la lumière entre la face arrière et un point dans le réseau à pas variable auquel la lumière est réfléchie. De ce fait, le laser va fonctionner sur la longueur d'onde de Bragg du point auquel la lumière est réfléchie. Une variation de la fréquence de modulation permet alors d'accorder la longueur d'onde d'émission du laser. Ainsi la source laser peut fonctionner sur l'une quelconque des fréquences comprises entre la première fréquence qui est la fréquence minimum et la seconde fréquence qui est la fréquence maximum. On note que la diode peut également fonctionner si la fréquence de modulation est un multiple entier de la fréquence définie ci-dessus. Ainsi la diode peut également fonctionner sur une fréquence se trouvant dans une plage continue de fréquences dont la fréquence minimum est un multiple entier de la première fréquence et dont la fréquence maximum est le même multiple entier de la seconde fréquence.

**Annexe**

**liste de documents pertinents de l'art antérieur.**

[1] H. Ishii et al, "Super structure grating (SSG) for broadly tunable DBR lasers" IEEE Photonics Technology Letters, Vol. 4, pages 393-395, 1993.

**Revendications**

1. Cavité optique résonante (50) ayant au moins une première partie munie d'un premier guide d'onde (3, 3') orienté selon un axe longitudinal sur lequel est définie une origine des distances, la cavité étant délimitée entre un premier et un second réflecteur (13', 40), le second des réflecteurs étant un réseau (40) réflecteur de Bragg à pas variable présent sur ledit premier guide d'onde (3, 3'), ledit réseau (40) du second réflecteur ayant une extrémité (41) proche du premier réflecteur (13', 40') et une extrémité plus éloignée du premier réflecteur, un paramètre $C_s$ de variation de longueur d'onde de Bragg défini comme la dérivée en un point du réseau (40) réflecteur de la longueur d'onde de Bragg $\lambda_B$ en ce point, par rapport à la distance séparant ce point à l'origine ayant une valeur donnée, **caractérisée en ce que** ladite valeur du paramètre $C_s$ et la position dudit réseau (40) par rapport à l'origine sont telles que la cavité (50) formée entre ledit premier réflecteur (13', 40') et ledit second réflecteur (40) est résonante de façon continue entre une première fréquence optique et une seconde fréquence optique supérieure à la première.

2. Cavité optique (50) résonante selon la revendication 1, **caractérisée en ce que** la valeur dudit paramètre $C_s$ est égale au quotient de la longueur d'onde optique $n_B\lambda_a$ dans ledit premier guide d'onde (3, 3') qui correspond à ladite deuxième valeur de fréquence, par la distance optique séparant ledit premier réflecteur (13') et l'extrémité (41) du réseau (40) la plus proche du premier réflecteur (13').

3. Cavité optique résonante (50) selon la revendication 1, **caractérisée en ce que** ladite cavité (50) comporte outre la première partie munie du premier guide d'onde (3, 3') une autre partie (4, 7) constituée par un guide (4) en semi-conducteur situé dans le prolongement optique de ladite première partie et couplé optiquement au premier guide.

4. Cavité optique résonante (50) selon la revendication 3, **caractérisée en ce que** ledit premier réflecteur est une face réfléchissante (13') à une extrémité dudit guide en semi-conducteur (4).

5. Cavité optique résonante (50) selon la revendication 3, **caractérisée en ce que** le premier réflecteur est un second réseau (40') réflecteur de Bragg porté par un second guide d'onde (3"), le premier réseau et le second réseau (40, 40') étant situés de part et d'autre dudit guide en semi-conducteur.

6. Cavité optique résonante (50) selon l'une des revendications 3 à 5, **caractérisée en ce que** le premier guide d'onde (3') est constitué aussi par un guide en semi-conducteur.

7. Cavité optique résonante (50) selon l'une des revendications 3 à 5, **caractérisée en ce que** le premier guide d'onde est constitué par une fibre optique (3).

8. Cavité optique résonante (50) selon la revendication 1, **caractérisée en ce que** le premier réflecteur (13', 40') est situé sur le même premier guide (3, 3') que celui portant ledit réseau (40) réflecteur de Bragg formant le second réflecteur.

9. Cavité optique résonante (50) selon la revendication 8, **caractérisée en ce que** le premier réflecteur est une face réfléchissante (13').

10. Cavité optique résonante (50) selon la revendication 1, **caractérisée en ce que** le premier réflecteur est aussi un réseau (40') réflecteur de Bragg à pas variable.

11. Utilisation d'une cavité résonante (50) selon l'une des revendications 3 à 5 pour réaliser un amplificateur en semi-conducteur, ledit guide (4) en semi-conducteur étant un guide amplificateur.

12. Utilisation d'une cavité résonante (50) selon l'une des revendications 1 à 5 ou 8 à 10 pour réaliser un filtre passe bande.

13. Utilisation d'une cavité résonante (50) selon l'une des revendications 3 à 5 pour réaliser un laser ou une diode électroluminescente à spectre d'émission continu, ledit guide (4) en semi-conducteur étant un guide amplificateur.

14. Utilisation d'une cavité résonante (50) selon l'une des revendications 3 à 5 pour réaliser une source laser accordable sur l'une des fréquences de la plage continue de fréquences de ladite cavité ou sur une fréquence se trouvant dans une plage continue de fréquences dont la fréquence minimum est un multiple entier de la première fréquence et dont la fréquence maximum est le même multiple entier de la seconde fréquence, ledit guide (4) en semi-conducteur étant un guide amplificateur.

FIG. 1

FIG. 2

## FIG. 3

## FIG. 4

40  3

41

13'

L1

# FIG. 5

20  10  50

13"  7  13

3"  40'  3  40

41'  14'  14  41

4

# FIG. 6

| Office européen des brevets | RAPPORT DE RECHERCHE EUROPEENNE | Numéro de la demande EP 02 29 2438 |

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | MORTON P A: "MODE-LOCKED HYBRID SOLITON PULSE SOURCE WITH EXTREMELY WIDE OPERATING FREQUENCY RANGE" IEEE PHOTONICS TECHNOLOGY LETTERS, IEEE INC. NEW YORK, US, vol. 5, no. 1, 1993, pages 28-31, XP000335389 ISSN: 1041-1135 * page 28, colonne de droite, dernière ligne; figure 1 * * page 29, colonne de droite, dernier alinéa * | 1,7-9, 11,13 | H01S5/14 H01S5/125 G02B6/12 |
| A | SCHRANS T ET AL: "TUNABLE ACTIVE CHIRPED-CORRUGATION WAVEGUIDE FILTERS" APPLIED PHYSICS LETTERS, AMERICAN INSTITUTE OF PHYSICS. NEW YORK, US, vol. 55, no. 3, 17 juillet 1989 (1989-07-17), pages 212-214, XP000046573 ISSN: 0003-6951 * figure 1 * | 1-4,6,8, 9,11-14 | |
| | | | DOMAINES TECHNIQUES RECHERCHES (Int.Cl.7) |
| A | LI SHENPING ET AL: "Wavelength-tunable picosecond pulses generated from stable self-seeded gain-switched laser diode with linearly chirped fibre Bragg grating" ELECTRONICS LETTERS, IEE STEVENAGE, GB, vol. 34, no. 12, 11 juin 1998 (1998-06-11), pages 1234-1236, XP006009866 ISSN: 0013-5194 * page 212, colonne de gauche; figure 1 * | 1 | H01S G02B |
| A | EP 1 133 036 A (SUMITOMO ELECTRIC INDUSTRIES) 12 septembre 2001 (2001-09-12) * colonne 12, ligne 28-42; figures 1,8 * * colonne 14, ligne 1-3 * | 1-14 | |

-/--

Le présent rapport a été établi pour toutes les revendications

| Lieu de la recherche | Date d'achèvement de la recherche | Examinateur |
|---|---|---|
| LA HAYE | 25 février 2003 | Claessen, L |

**Office européen
des brevets**

**RAPPORT DE RECHERCHE EUROPEENNE**

Numéro de la demande

EP 02 29 2438

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 6 088 373 A (HAKKI BASIL WAHID) 11 juillet 2000 (2000-07-11) * le document en entier * ----- | 1 | |
| | | | **DOMAINES TECHNIQUES RECHERCHES (Int.Cl.7)** |

Le présent rapport a été établi pour toutes les revendications

| Lieu de la recherche | Date d'achèvement de la recherche | Examinateur |
|---|---|---|
| LA HAYE | 25 février 2003 | Claessen, L |

CATEGORIE DES DOCUMENTS CITES

X : particulièrement pertinent à lui seul
Y : particulièrement pertinent en combinaison avec un autre document de la même catégorie
A : arriere-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.......................................................................................
& : membre de la même famille, document correspondant

EPO FORM 1503 03 82 (P04C02)

12

**ANNEXE AU RAPPORT DE RECHERCHE EUROPEENNE
RELATIF A LA DEMANDE DE BREVET EUROPEEN NO.**          EP 02 29 2438

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-02-2003

| Document brevet cité au rapport de recherche | Date de publication | Membre(s) de la famille de brevet(s) | Date de publication |
|---|---|---|---|
| EP  1133036       A | 12-09-2001 | JP   2001257422 A<br>EP      1133036 A2<br>US   2001021210 A1 | 21-09-2001<br>12-09-2001<br>13-09-2001 |
| US  6088373       A | 11-07-2000 | AUCUN | |

EPO FORM P0460

Pour tout renseignement concernant cette annexe : voir Journal Officiel de l'Office européen des brevets, No. 12/82